# EUROPEAN PATENT APPLICATION

(11) **EP 4 797 930 A1**
(43) Date of publication of application: **26.08.2026**
(21) Application number: 26159203.4
(22) Date of filing: 18.02.2026
(51) Int. Cl.: H10P 72/00, H10P 72/10

(54) **SUPPORT STRUCTURE**

(30) Priority: 21.02.2025 US 202563761383 P
(71) Applicant: ASM IP Holding B.V., 1322 AP Almere (NL)
(72) Inventor: VAN HAASTERT, Simon, 1322 AP Almere (NL); JDIRA, Lucian, 1322 AP Almere (NL); OOSTERLAKEN, Theodorus G.M., 1322 AP Almere (NL); GANANI, Chaggai Shmuel, 1322 AP Almere (NL); YUKANANTO, Riza, 1322 AP Almere (NL)
(74) Representative: V.O.

(57) **Abstract**

A support structure for a wafer boat is disclosed. The support structure comprises a top member and a bottom member spaced apart along a central axis of the support structure; at least three rods, each extending between the top member and the bottom member; and a plurality of heat shields disposed between the top member and the bottom member and spaced apart along the central axis. The rods are hollow. The heat shields each have a diameter which is greater than twice a distance from any rod to the central axis.

## Description

### FIELD

The present disclosure relates generally to the field of semiconductor processing methods, and associated structures and apparatus, and to the field of device and integrated circuit manufacture. More particularly the present disclosure generally relates to support structures for wafers or wafer boats having improved heat insulation properties.

### BACKGROUND

In the field of semiconductor manufacturing, vertical furnaces commonly used for batch processing of semiconductor devices. These furnaces typically comprise several key components, including a process chamber where the wafers are treated, a door that seals the chamber, heating coils that provide the necessary thermal energy to the chamber, a pedestal that supports the wafer boat, and the wafer boat itself, which holds the wafers in place during processing. The vertical orientation of these furnaces allows for efficient use of space and facilitates the uniform treatment of multiple wafers simultaneously.

One challenge in the operation of vertical furnaces is the issue of heat loss from the bottom of the process chamber. This heat loss can lead to temperature gradients within the chamber, which in turn can affect the uniformity of the wafer processing. Uneven temperatures can result in non-uniform deposition or diffusion, potentially compromising the quality and performance of the semiconductor devices. Additionally, the heat loss can damage temperature-sensitive components in the flange, such as seals, gaskets, and electronic sensors, which are critical for maintaining the integrity and functionality of the furnace. Addressing this issue is important to ensure consistent wafer quality and to meet the demands of modern semiconductor manufacturing. Solutions that improve thermal management and reduce heat loss are helpful for maintaining the efficiency of batch processing in vertical furnaces.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a support structure for a wafer boat, the support structure comprising a top member and a bottom member that are spaced apart along a central axis, at least three rods extending between the top and bottom members, and a plurality of heat shields positioned between the top member and the bottom member, spaced along the central axis. The rods are hollow, and the heat shields have a diameter greater than twice the distance from any rod to the central axis.

By providing a pedestal or support structure with hollow rods, conduction of heat along the support structure can be reduced. This can help to reduce heat loss through the bottom of a process chamber in which the support structure is positioned.

By providing heat shields in the support structure with a diameter greater than twice the distance from any rod to the central axis, radiative heat transfer along the support structure can be reduced, as the heat shields may reflect not only radiation incident at positions between the rods but also at positions which are further from the central axis than the rods are. This can help to reduce heat loss through the bottom of a process chamber in which the support structure is positioned.

The rods may be sealed at one or both ends, and may be free of inlets, outlets, manifolds, or passages that establish fluid communication with a process environment.

The heat shields may each have a thickness of between 0.5mm and 3mm. The heat shields may have a thickness of between 0.5mm and 2mm.

The wall thickness of the rods in the support structure may range between 2mm and 4mm.

The rods may include slots that may support the heat shields.

The three rods in the support structure may include first and second side rods and a back rod.

The first and second side rods may be positioned to create an opening opposite the back rod, with the opening having a width less than the diameter of the heat shields.

The heat shields may have cutouts at circumferential positions that overlap with the circumferential positions of the rods. The cutouts at circumferential positions overlapping with the side rods may have a shape such that the shortest distance between the two cutouts increases along a direction in the plane of the heat shield and perpendicular to the direction in which the two cutouts are spaced apart. The cutouts at circumferential positions overlapping with the side rods may have a stepped shape.

At least some of the heat shields may include at least three support pins projecting away from a bottom planar face of the heat shield. The heat shields may be stacked in the support structure so that an upper heat shield placed upon a lower heat shield is supported by the support pins of the upper heat shield, which contact the lower heat shield.

At least some of the heat shields may include at least one recess in an upper planar face of the heat shield. The heat shields may be stacked in the support structure so that a support pin of an upper heat shield is positioned within a recess of a lower heat shield upon which the upper heat shield is placed.

The top member of the support structure may include an upper surface with at least one boat support recess where a part of a wafer boat may be positioned.

The rods may extend through and above the top member to provide support points on which a wafer boat may be positioned.

According to a second aspect of the present invention there is provided a wafer boat including a top member and a bottom member spaced apart along a central axis, with at least three rods extending between them. The rods are hollow along a lower section and solid along an upper section.

By providing a wafer boat with hollow rods, conduction of heat along the wafer boat can be reduced. This can help to reduce heat loss through the bottom of a process chamber in which the wafer boat is positioned.

The rods may be sealed at one or both ends, and may be free of inlets, outlets, manifolds, or passages that establish fluid communication with a process environment.

The upper section of the rods may be at least twice as long as the lower section. The wall thickness of the rods at the lower section may range between 2mm and 4mm.

The upper section of the rods may include a plurality of supports for supporting wafers.

The rods may include slots at the lower section for supporting heat shields. A plurality of heat shields may be disposed in the lower section of the wafer boat, spaced along the central axis, with each heat shield having a diameter greater than twice the distance from any rod to the central axis.

By providing heat shields in the wafer boat with a diameter greater than twice the distance from any rod to the central axis, radiative heat transfer through the lower section of the wafer boat can be reduced, as the heat shields may reflect not only radiation incident at positions between the rods but also at positions which are further from the central axis than the rods are. This can help to reduce heat loss through the bottom of a process chamber in which the wafer boat is positioned.

The heat shields may have cutouts at circumferential positions overlapping with the circumferential positions of the rods.

The three rods in the wafer boat may include first and second side rods and a back rod, with the first and second side rods positioned to create an opening opposite the back rod, having a width less than the diameter of the heat shields.

The cutouts at circumferential positions overlapping with the side rods may have a shape such that the shortest distance between the two cutouts increases along a direction in the plane of the heat shield and perpendicular to the direction in which the two cutouts are spaced apart. The cutouts at circumferential positions overlapping with the side rods may have a stepped shape.

At least some of the heat shields may include at least three support pins projecting away from a planar face of the heat shield. The heat shields may be stacked in the wafer boat so that an upper heat shield placed upon a lower heat shield is supported by the support pins of the upper heat shield, which contact the lower heat shield.

At least some of the heat shields may include at least one recess in an upper planar face of the heat shield. The heat shields may be stacked in the wafer boat so that a support pin of an upper heat shield is positioned within a recess of a lower heat shield upon which the upper heat shield is placed.

The wafer boat may be made of quartz, silicon, or silicon carbide. The support structure may be made of quartz, silicon, or silicon carbide. The heat shields may be made of quartz, silicon, or silicon carbide. Silicon carbide may be preferred as a heat shield material for its reflective properties.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a perspective view of a first support structure according to embodiments of the present invention;
FIG. 2 is a cut-through view of the first support structure of FIG. 1, showing a cross-section of a rod in a vertical plane;
FIG. 3 is a perspective view of a first support structure according to embodiments of the present invention comprising a plurality of heat shields;
FIG. 4 is a plan view of a first support structure according to embodiments of the present invention, viewed perpendicular to a horizontal plane which intersects the rods;
FIG. 5 shows two perspective views of a first heat shield which may be comprised in a support structure according to embodiments of the present invention, with the lower illustration indicating various distances and directions;
FIG. 6 illustrates steps for inserting heat shields into the first support structure according to embodiments of the present invention;
FIG. 7 is a perspective view of a first heat shield comprising recesses, along with a cross-sectional view of the first heat shield along the dotted line;
FIG. 8 is a perspective view of a first heat shield comprising support pins, along with a cross-sectional view of the first heat shield along the dotted line;
FIG. 9 is a perspective view of a second support structure according to embodiments of the present invention comprising heat shields;
FIG. 10 is a perspective view of the second support structure of FIG. 9, shown without heat shields;
FIG. 11 is a plan view of a second support structure according to embodiments of the present invention, viewed perpendicular to a horizontal plane which intersects the rods;
FIG. 12 is a perspective view of a second heat shield, along with a cross-sectional view of the second heat shield along the dotted line;
FIG. 13 is a plan view of a first support structure according to embodiments of the present invention, viewed perpendicular to a horizontal plane which intersects the rods, showing a first heat shield positioned in the first support structure;
FIG. 14 is a plan view of a second support structure according to embodiments of the present invention, viewed perpendicular to a horizontal plane which intersects the rods, showing a second heat shield positioned in the second support structure;
FIG. 15 is a side view of a support structure according to embodiments of the present invention on which a wafer boat is positioned, the support structure comprising rods providing positions for supporting the wafer boat;
FIG. 16 is a side view of a support structure according to embodiments of the present invention on which a wafer boat is supported, the support structure comprising a top member with recesses for supporting the wafer boat;
FIG. 17 is a perspective view of a wafer boat according to embodiments of the present invention comprising rods which are partially hollow;
FIG. 18 is a cross-sectional cutout view of the wafer boat of FIG. 17, showing a cross-section of a rod in a vertical plane;
FIG. 19 is a cross-sectional view, in a vertical plane, of a rod comprised in a wafer boat according to embodiments of the present invention;
FIG. 20 is a plan view of a wafer boat according to embodiments of the present invention, viewed perpendicular to a horizontal plane which intersects the rods.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

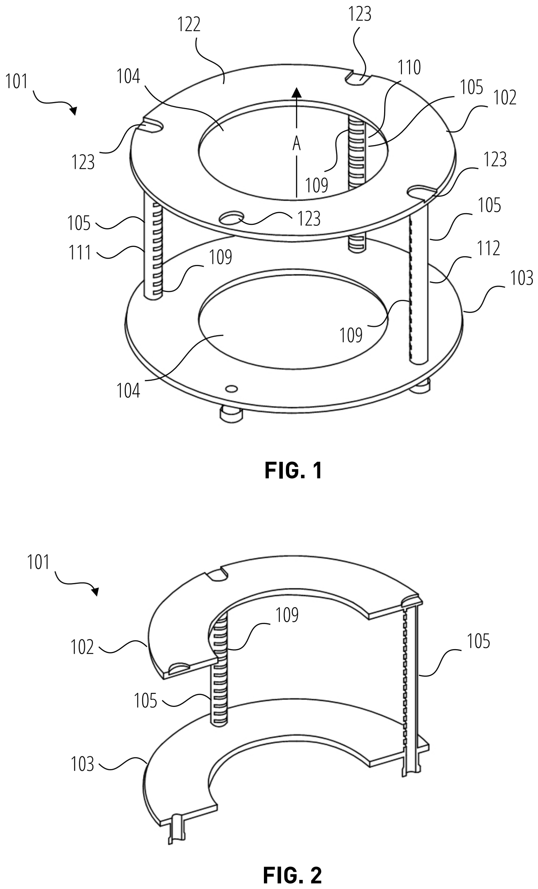

Referring to FIG. 1, FIG. 2, FIG. 3, and FIG. 4, a first support structure 101 according to embodiments of the present invention is shown. The first support structure 101 comprises a top member 102 and a bottom member 103, which are spaced apart along a central axis A of the first support structure 101. The top member 102 and the bottom member 103 may be generally disk-shaped. The top member 102 and the bottom member 103 may each comprise a central open region 104 which may help to reduce thermal stress on the first support structure 101 and reduce the probability of cracking when subjected to large temperature changes.

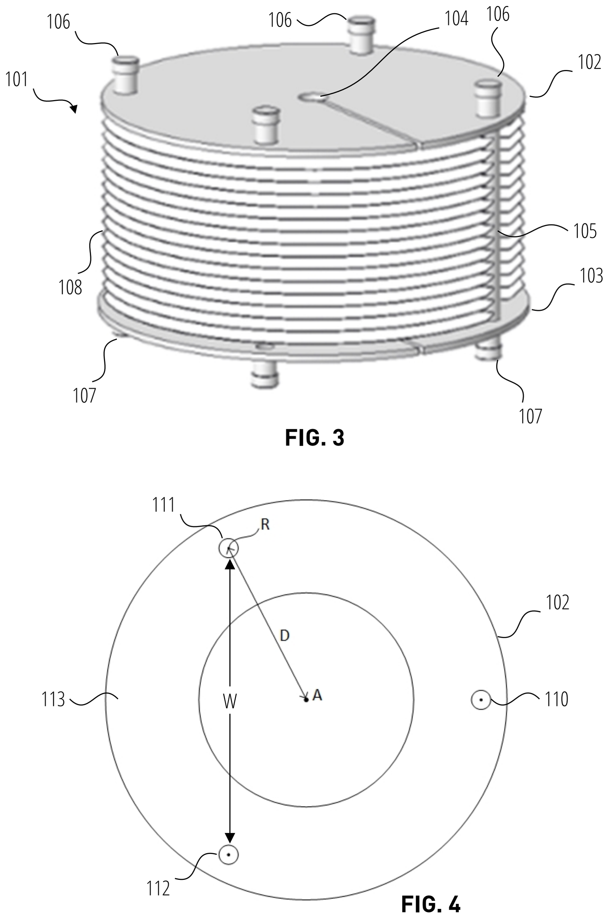

The first support structure 101 comprises at least three rods 105, each extending between the top member 102 and the bottom member 103. The rods 105 may be generally tubular or cylinder shaped. Referring to FIG. 4 in particular, each of the rods 105 is located at a distance D from the central axis A, which is the same for each rod 105. The distance D is measured from a central axis R of a rod 105, parallel to the central axis A of the first support structure 101. The rods 105 are hollow, which can help to reduce heat loss by conduction via the pedestal due to the decreased cross-sectional area of the rods 105 in a plane perpendicular to the central axis, as compared to rods which are solid. The rods 105 may each have a top end which may be fixed to the top member 102 and a bottom end which may be fixed to the bottom member 103. The top end 106 and/or the bottom end 107 may be closed off or may be open. A wall thickness of the hollow rods 105 may be between 1mm and 5mm, preferably between 2mm and 4mm, more preferably between 2.5mm and 3.5mm. The wall thickness may be chosen so as to provide a significant reduction in heat loss by conduction while still retaining sufficient strength to support a loaded wafer boat on the first support structure 101.

The first support structure 101 comprises a plurality of heat shields 108 disposed between the top member 102 and the bottom member 103. The heat shields 108 are spaced apart along the central axis A. The heat shields 108 may help to reduce radiative heat loss via the pedestal by reflection.

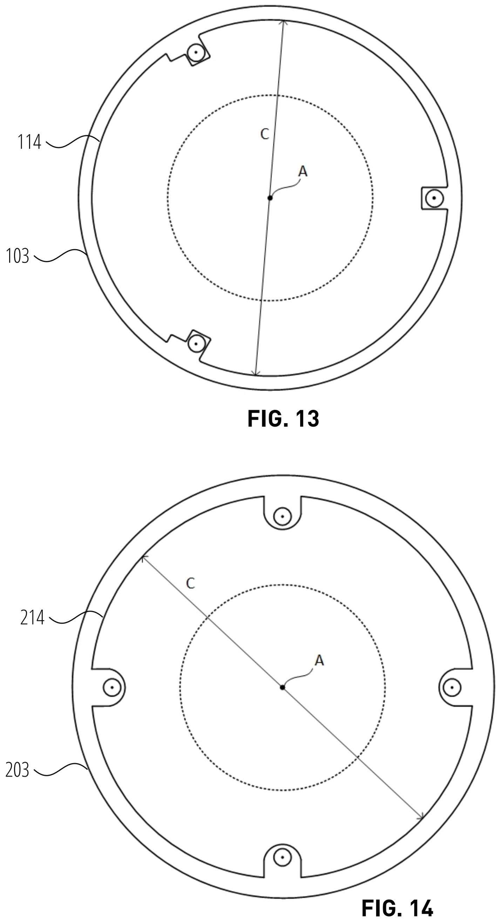

The heat shields 108 each have a diameter C (FIG. 13) which is greater than twice the distance D from the central axis R of any rod 105 to the central axis A of the first support structure 101. By providing the first support structure 101 with heat shields 108 which extend beyond the rods 105, the radiative heat shielding by the heat shields 108 may be improved.

The rods 105 may comprise a plurality of slots spaced apart in a direction parallel to the central axis A. The slots may be provided in sets, with one slot in each of the rods 105 at a set height, so as to provide a set of vertically spaced apart positions for supporting the heat shields 108.

The rods 105 may comprise a back rod 110, a first side rod 111, and a second side rod 112. The first side rod 111 and the second side rod 112 may be positioned so as to provide an opening 113 opposite the back rod 110. The opening 113 may have a width W of less than a diameter C of the heat shields, which may help to provide a more stable first support structure 101 while still allowing for insertion and removal of heat shields 108 from the first support structure 101 without requiring the first support structure 101 to be dismantled.

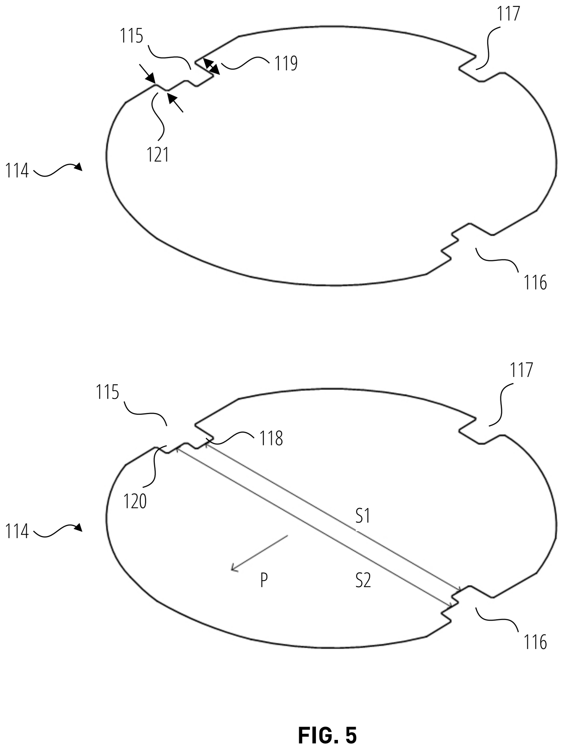

Referring to FIG. 5, a first heat shield 114 which may be comprised in a first support structure 101 according to embodiments of the present invention has a generally circular shape. The first heat shield 114 comprises cutouts at circumferential positions overlapping with circumferential positions of the rods 105. The cutouts comprise a first cutout 115 at a circumferential position overlapping with a circumferential position of the first side rod 111 when installed in the first support structure 101, a second cutout 116 at a circumferential position overlapping with a circumferential position of the second side rod 112 when installed in the first support structure 101, and a third cutout 117 at a circumferential position overlapping with a circumferential position of the back rod 110 when installed in the first support structure 101. The cutouts are formed such that a radius of the first heat shield 114 at a circumferential position of a cutout is less than a radius of the first heat shield 114 at a circumferential position away from a cutout. Put differently, the cutouts are not holes in the first heat shield 114 but are regions of reduced radius.

The first cutout 115 and the second cutout 116 may each have a shape such that a shortest distance between the first cutout 115 and the second cutout 116 increases along a direction P which is in a plane of the first heat shield 114 and perpendicular to a direction in which the first cutout 115 and the second cutout 116 are spaced apart, wherein the direction P is pointing away from the third cutout 117 towards an opposite edge of the first heat shield 114. The shortest distance may increase from a distance that is greater than the width of the opening 113 to a distance than is less than the width of the opening 113. This may allow for the first heat shield 114 to be removable without dismantling the first support structure 101, while still providing improved radiation shielding at positions extending beyond the rods 105, due to the first heat shield 114 having a diameter that is greater than the width of the opening 113. The first cutout 115 and the second cutout 116 may have a stepped shape. For example, the first cutout 115 may comprise a first section 118 having a first width 119 in a direction in which the first cutout 115 and the second cutout 116 are spaced apart; and a second section 120 having a second width 121 in a direction in which the first cutout 115 and the second cutout 116 are spaced apart. The first section 118 may be closer to the back rod 110 than the second section 120 is and the first width 119 may be greater than the second width 121. The second cutout 116 may have the same form. The third cutout 117 may have a generally square or rectangular shape. The third cutout 117 may comprise a straight section which is substantially perpendicular to a radius bisecting the straight section. The straight section may allow for a secure seating of the first heat shield 114 at the back rod 110.

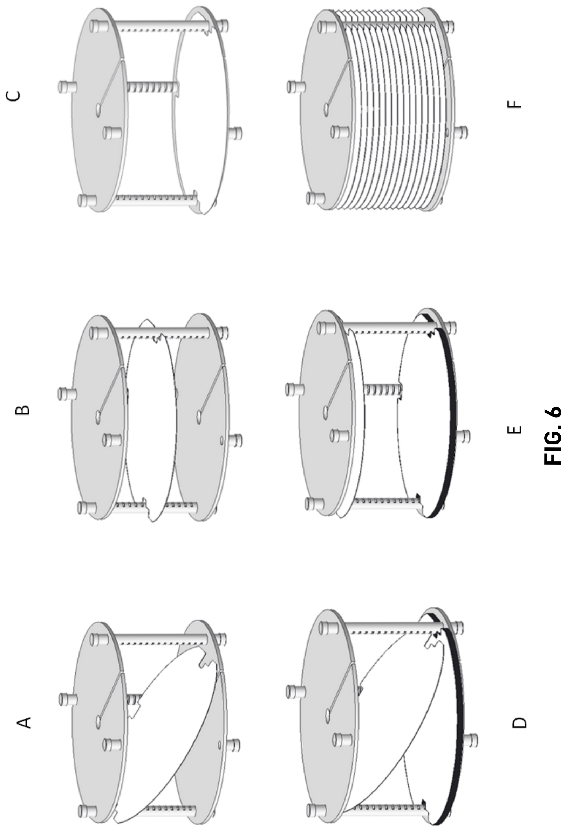

Referring to FIG. 6, the first heat shield 114 may be inserted into the first support structure 101 via the opening 113, with an orientation that is oblique with respect to the bottom member 103, step A. Since the width W of the opening 113 is less than the diameter C of the first heat shield 114, the insertion must be at an oblique angle. The first heat shield 114 is positioned such that the first side rod 111 and the second side rod 112 are positioned in the first section 118 of the first cutout 115 and the second cutout 116 respectively, step B. The first heat shield 114 is then moved downwards and placed upon the bottom member 103, step C. Additional first heat shields 114 are arranged in the first support structure 101 in the same way, being stacked on top of each other on the bottom member, step D. When all required first heat shields 114 have been stacked in the first support structure 101, each first heat shield 114 is moved in turn to a support position in slots 109 as follows. The first heat shield 114 is moved vertically upwards to the vertical position of the required slots 109. The first heat shield 114 is moved towards the back rod 110 such that the second section 120 of the first cutout 115 and the second cutout 116 overlaps with the first side rod 111 and the second side rod 112, step E. The edge of the first heat shield 114 may then be supported in slots 109 in the first side rod 111, the second side rod 112, and the back rod 110. The process is repeated for each first heat shield 114 until all first heat shields 114 are supported in slots 109, step F.

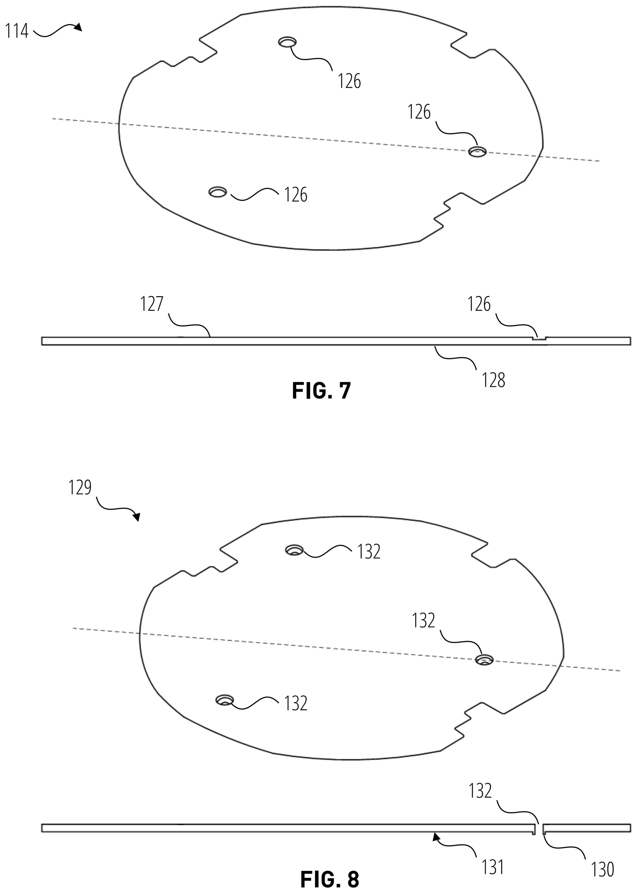

Referring to FIG. 7, in some embodiments, the first heat shield 114 comprises a plurality of recesses 126 in a top face 127 of the first heat shield 114. The recesses 126 may comprise three, four or more recesses. The recesses may have a diameter of between 5mm and 30mm. Preferably, the recesses 126 each have the same diameter. The recesses 126 may be positioned at substantially equally spaced angular intervals with respect to the central axis A. The recesses 126 may be positioned at substantially equal distances from the central axis A. The recesses 126 may be blind recesses or may be through holes having a diameter which decreases from the top face 127 to a bottom face of the first heat shield 114.

Referring to FIG. 8, in some embodiments, stackable heat shields 129 may be provided along with first heat shields having recesses 126. The stackable heat shields 129 may have the same shape as first heat shields 114 without recesses 126. The stackable heat shield 129 comprises a plurality of support pins 130, each of which project away from a bottom face 131 of the stackable heat shield 129. The support pins 130 may each have a circular shape. The support pins 130 may be circular projections around a circumference of a through-hole 132 in the stackable heat shield 129. The support pins 130 may be circular projections and the stackable heat shield 129 may not comprise the through-hole 132. The support pins 130 may comprise three, four or more support pins. The support pins 130 may have a diameter of between 5mm and 30mm. Preferably the support pins 130 each have the same diameter. Preferably the support pins 130 each have a diameter which is equal to or greater than the diameter of the recesses 126. The support pins 130 may be positioned at substantially equally spaced angular intervals with respect to the central axis A. The support pins 130 may be positioned at substantially equal distances from the central axis A.

The support pins 130 may provide means for spacing apart a stackable heat shield 129 from a first heat shield 114 comprising recesses 126, in a direction along the central axis A without requiring slots, supports, or other support means in the rods 105 for the stackable heat shield 129. The stackable heat shield 129 may be positioned on a first heat shield 114 such that the support pins 130 are positioned in recesses 126, providing a stable seating for the stackable heat shield 129. This can allow the number of heat shields provided in the first support structure 101 to be varied without requiring structural modification of the first support structure 101. In some embodiments, a stackable heat shield 129 may be stacked on a first heat shield 114 which does not comprise recesses 126.

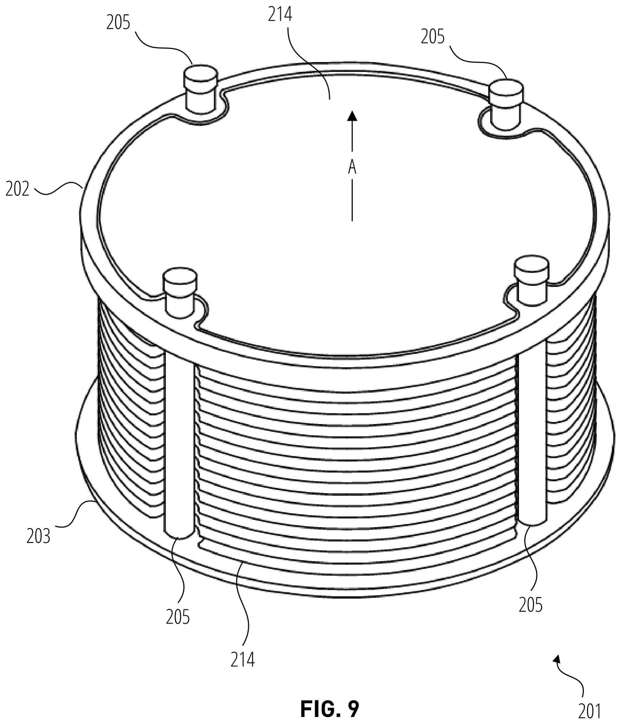

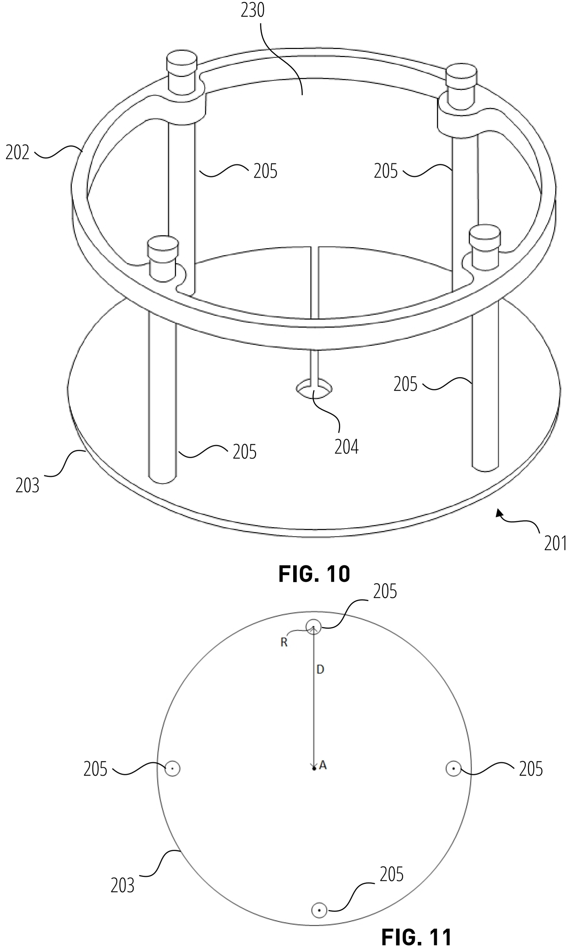

Referring to FIG. 9 and FIG. 10, a second support structure 201 according to embodiments of the present invention is shown. The second support structure 201 comprises a top member 202 and a bottom member 203, which are spaced apart along a central axis A of the second support structure 201. The top member 202 may be generally ring shaped, with an aperture 230 which allows insertion of second heat shield therethrough. The bottom member 203 may be generally disk-shaped. The bottom member 203 may comprise a central open region 204 which may help to reduce thermal stress on the second support structure 201 and reduce the probability of cracking when subjected to large temperature changes.

The second support structure 201 comprises at least three rods 205, preferably four rods 205, each extending between the top member 202 and the bottom member 203. The rods 205 may be generally tubular or cylinder shaped. Referring to FIG. 11, each of the rods 205 is located at a distance D from the central axis A, which is the same for each rod 205. The distance D is measured from a central axis R of a rod 205, parallel to the central axis A of the second support structure 201. The rods 205 may be distributed at regular angular positions. An angle subtended by any two adjacent rods at the central axis may be the same for any two adjacent rods 205.

The rods 205 are hollow, which can help to reduce heat loss by conduction via the pedestal due to the decreased cross-sectional area of the rods 205 in a plane perpendicular to the central axis, as compared to rods which are solid. The rods 205 may each have a top end which may be fixed to the top member 202 and a bottom end which may be fixed to the bottom member 203. The top end and/or the bottom end may be closed off or may be open. A wall thickness of the hollow rods 205 may be between 1mm and 5mm, preferably between 2mm and 4mm, more preferably between 2.5mm and 3.5mm. The wall thickness may be chosen so as to provide a significant reduction in heat loss by conduction while still retaining sufficient strength to support a loaded wafer boat on the second support structure 201. The rods 205 may be free of support positions for heat shields, that is, may not comprise slots or projections for supporting heat shields.

The second support structure 201 comprises a plurality of second heat shields 214 disposed in the second support structure 201. The second heat shield 214 are spaced apart along the central axis A. The second heat shields 214 may help to reduce radiative heat loss via the pedestal by reflection.

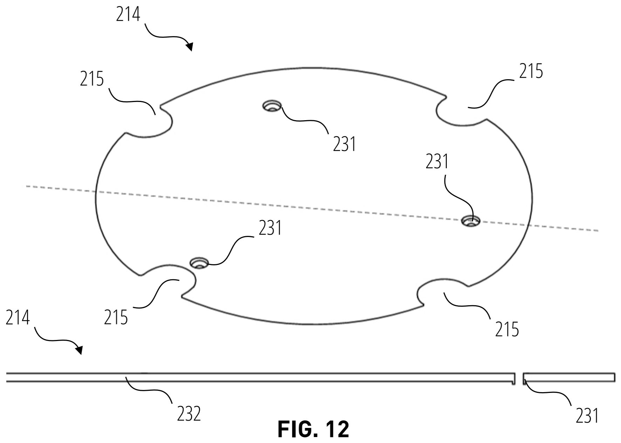

Referring to FIG. 12, a second heat shield 214 which may be comprised in a second support structure 201 according to embodiments of the present invention has a generally circular shape. The second heat shield 214 comprises cutouts 215 at circumferential positions overlapping with circumferential positions of the rods 205. The number of cutouts 215 is equal to or greater than the number of rods 205. The cutouts 215 are formed such that a radius of the second heat shield 214 at a circumferential position of a cutout 215 is less than a radius of the second heat shield 214 at a circumferential position away from the cutout. Put differently, the cutouts 215 are not holes in the second heat shield 214 but are regions of reduced radius. The cutouts 215 may have a semicircular shape as viewed in a direction parallel to the central axis A.

The second heat shields 214 each have a diameter C (FIG. 14) which is greater than twice the distance D from the central axis R of any rod 205 to the central axis A of the second support structure 201. By providing the second support structure 201 with second heat shield 214 which extend beyond the rods 205, the radiative heat shielding by the second heat shield 214 may be improved.

The second heat shield 214 may be placed in the second support structure 201 by lowering through the aperture 230 and stacking on top of each other. Referring to FIG. 12, the second heat shields 214 may each comprise a plurality of support pins 231, each of which project away from a bottom planar face 232 of the second heat shield 214. The support pins 231 may each have a circular shape. The support pins 231 may be circular projections around a circumference of a through-hole in the second heat shield 214. The support pins 231 may comprise three, four or more support pins. The support pins 231 may have a diameter of less than 10mm. The support pins 231 may be positioned at substantially equally spaced angular intervals with respect to the central axis A. The support pins 231 may be positioned at substantially equal distances from the central axis A.

The support pins 231 may provide means for spacing apart second heat shields 214 in a direction perpendicular to the bottom planar face 232 without the rods 205 requiring slots, supports, or other support means for the second heat shields 214.

In some embodiments, the cutouts 215 are through holes in the second heat shield 214. In such embodiments, the cutouts 215 are not regions of reduced radius and the second heat shield 214 may have a constant radius at all points around the circumference of the second heat shield 214. Such a second heat shield 214 may be inserted in the second support structure 201 by removing the top member 202, aligning the cutouts 215 with the rods 205 and sliding the heat shield down the rods 205. The top member 202 may be replaced once all heat shields are placed.

Referring to FIG. 13 and FIG. 14, when a diameter of a heat shield 108, 114, 129, 214 is referred to, it will be understood that the diameter C is measured along a line which connects two points on a circumference of the heat shield in question and passes through a point on the central axis A. The two points are located away from the cutouts 115, 116, 117, 215 and thus the diameter C is a maximum diameter of the heat shield.

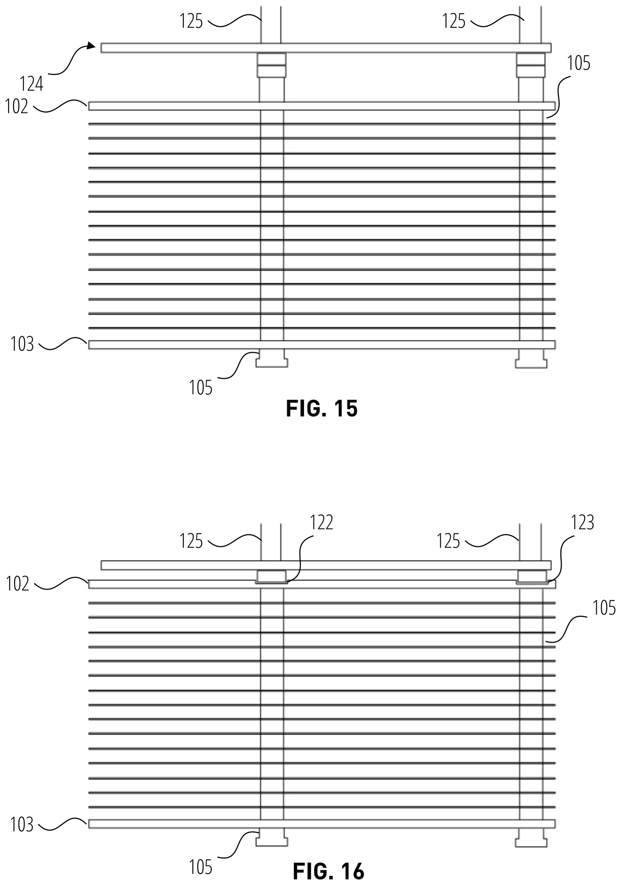

Referring to FIG. 10 and FIG. 15, in some embodiments, in the first support structure 101 or the second support structure 201, the rods 105, 205 may extend through and above the top member 102, 202 so as to provide supports on which a wafer boat 124 may be positioned. For example, wafer boat rods 125 may be supported on top ends of the rods 105, 205.

Referring to FIG. 1 and FIG. 16, in some embodiments, the top member 102, 202 comprises an upper surface 122 comprising at least one boat support recess 123 in which a part of a wafer boat 124, for example a wafer boat rod 125, may be positioned. The top member 102, 202 may comprise three, four, or more boat support recesses 123.

In some embodiments, a support structure according to embodiments of the present invention may have a top member 102, 202 having an upper surface which is flat and upon which a wafer boat may be positioned.

By using a support structure according to embodiments of the present invention as a support or pedestal for a wafer boat in a vertical furnace or other batch processing apparatus, heat loss through the pedestal or support structure can be reduced due to both decreased conduction loss through the rods, due to their hollow nature, and decreased radiation loss due to the large diameter heat shields, which may reflect radiation at an increased range of radial positions.

Instead of providing a separate support structure upon which a wafer boat may be supported, a wafer boat may be provided according to embodiments of the present invention which comprises space for large diameter heat shields along with partially hollow boat rods, and the wafer boat may be supported directly on a doorplate of a vertical furnace or batch processing apparatus without the need for a support structure or pedestal.

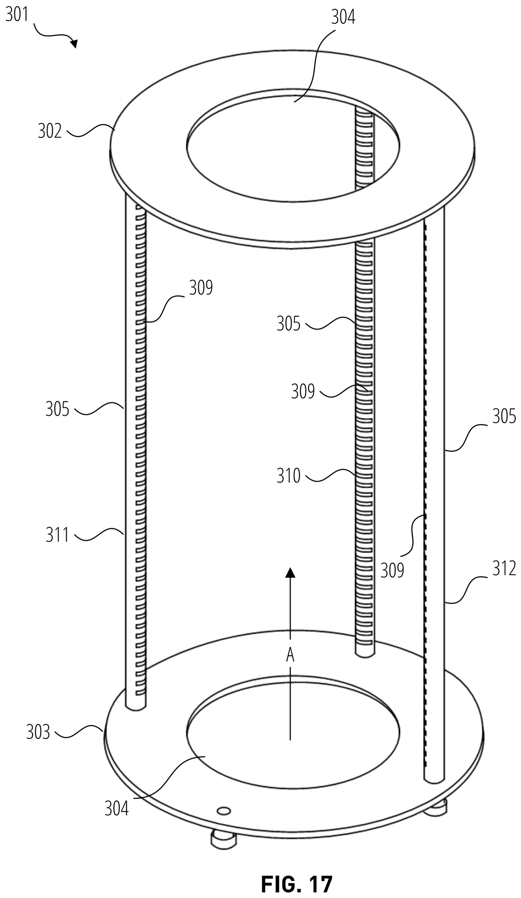

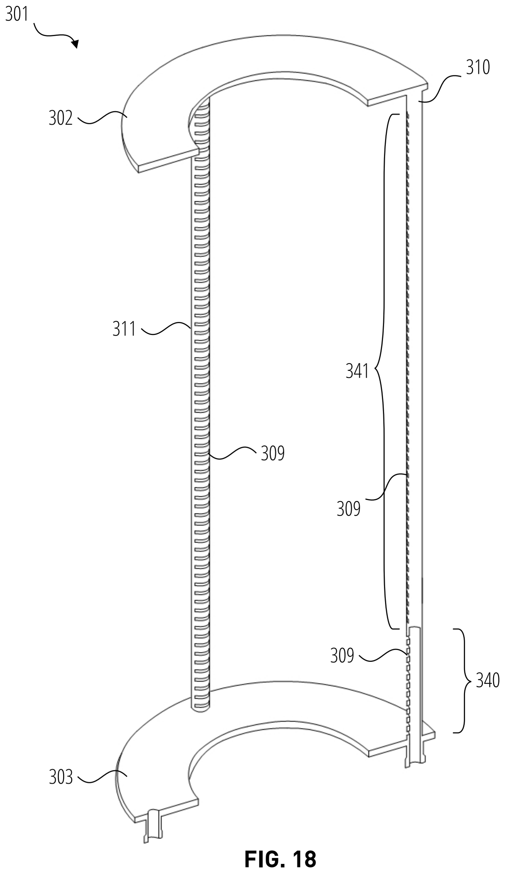

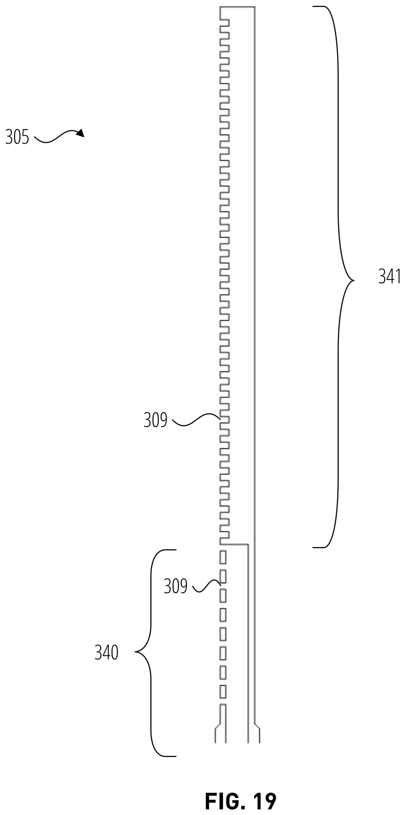

Referring to FIG. 17, FIG. 18, FIG. 19, and FIG. 20, a wafer boat 301 according to embodiments of the present invention may comprise a top member 302 and a bottom member 303 spaced apart along a central axis A of the boat 301. The top member 302 and the bottom member 303 may each comprise a central open region 304 which may help to reduce thermal stress on the boat 301 and reduce the probability of cracking when subjected to large temperature changes.

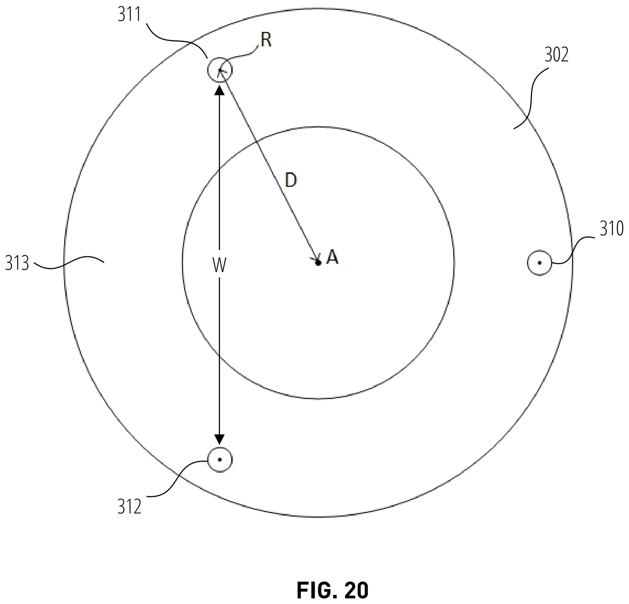

The wafer boat 301 comprises at least three rods 305, each extending between the top member 302 and the bottom member 303. The rods 305 may be generally tubular or cylinder shaped. Referring to FIG. 20 in particular, each of the rods 305 is located at a distance D from the central axis A, which is the same for each rod 305. The distance D is measured from a central axis R of a rod 305, parallel to the central axis A of the wafer boat 301.

The rods 305 are hollow along a lower section 340 of the rods and solid along an upper section 341 of the rods, the lower section 340 being attached to the bottom member 303 and the upper section 341 being attached to the top member 302. By providing rods 305 with a hollow lower section 340, heat loss by conduction via the lower section of the rods may be decreased due to the decreased cross-sectional area of the lower section of the rods 305 in a plane perpendicular to the central axis, as compared to rods which are solid along their full length. By providing rods 305 with a solid upper section 341, the strength of the rods 305 may be improved as compared with rods which are hollow along their full length. Additionally, deposition of precursors may be prevented inside the rods 305 at positions where wafers may be supported, which may reduce the risk of particle contamination.

A wall thickness of the lower section 340 of the rods 305 may be between 1mm and 5mm, preferably between 2mm and 4mm, more preferably between 2.5mm and 3.5mm. The wall thickness may be chosen so as to provide a significant reduction in heat loss by conduction via the lower section 340 while still retaining sufficient strength to support a plurality of wafers at the upper section 341.

The rods 305 may comprise a plurality of slots 309 spaced apart in a direction parallel to the central axis A. The slots 309 may be provided in sets, with one slot in each of the rods 305 at a set height, so as to provide a set of vertically spaced apart positions for supporting heat shields or wafers. A vertical spacing between the slots 309 may be the same in the lower section 340 as in the upper section 341, or may be different. In some embodiments, the vertical spacing between the slots 309 in the lower section 340 is smaller than the vertical spacing between the slots 309 in the upper section 341. In some embodiments, the vertical spacing between the slots 309 in the lower section 340 is greater than the vertical spacing between the slots 309 in the upper section 341. The lower section 340 may comprise between 5 and 30 slots. The upper section 341 may comprise at least 80 slots, at least 100 slots, at least 120 slots, at least 150 slots, or between 160 and 180 slots. The upper section 341 may be at least twice as long as the lower section 340, at least three times or at least four times as long as the lower section 340.

In some embodiments, the rods 305 may comprise a back rod 310, a first side rod 311, and a second side rod 312. The first side rod 311 and the second side rod 312 may be positioned so as to provide an opening 313 opposite the back rod 310. The opening 313 may have a width W of less than a diameter C of the heat shields, which may help to provide a more stable boat 301 while still allowing for insertion and removal of heat shields from the boat 301 without requiring the boat 301 to be dismantled.

The boat 301 may comprise a plurality of heat shields 108 disposed in the boat 301 at vertical positions distributed along the lower section 340. The heat shields 108 may be spaced apart along the central axis and may each have a diameter which is greater than twice a distance from any rod 305 to the central axis A. In some embodiments, the lower section 340 comprises slots 309 and the heat shields comprise first heat shields 114. In some embodiments, the lower section 340 may or may not comprise slots and the heat shields may comprise stackable heat shields 129. The heat shields may be inserted into the boat 301 in the same or similar manner as described in relation to FIG. 6.

In some embodiments, a first heat shield 114 may be placed in a slot 309 and a stackable heat shield 129 may be supported on the first heat shield 114 by means of support pins 130, without needing to be received in a slot. This can allow for the number of heat shields disposed in a boat 301 with a set number of slots 309 to be varied, even increased above the number of vertical support positions provided by the slots 309. The first heat shields 114 may or may not comprise recesses 126.

In some embodiments, slots 309 may be provided in the upper section 341 only and the lower section 340 may be free of slots. In some embodiments, the upper section 341 may comprise wafer supports other than slots; for example, the upper section 341 may comprise a series of vertically spaced apart projections on which wafers may be supported.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A support structure for a wafer boat, comprising:
a top member and a bottom member spaced apart along a central axis of the support structure;
at least three rods, each extending between the top member and the bottom member;
a plurality of heat shields disposed between the top member and the bottom member and spaced apart along the central axis;
wherein the rods are hollow;
wherein the heat shields each have a diameter which is greater than twice a distance from any rod to the central axis.

2. The support structure of claim 1, wherein a wall thickness of the rods is between 2mm and 4mm.

3. The support structure of claim 1 or 2, wherein the rods comprise slots for supporting the heat shields.

4. The support structure of any one of claims 1 to 3, wherein the three rods comprise first and second side rods and a back rod, the first and second side rods being positioned so as to provide an opening opposite the back rod, the opening having a width of less than a diameter of the heat shields.

5. The support structure of claim 4, wherein the heat shields comprise cutouts at circumferential positions overlapping with circumferential positions of the rods.

6. The support structure of claim 5, wherein the cutouts at circumferential positions overlapping with circumferential positions of the side rods each have a shape such that a shortest distance between the two cutouts increases along a direction in a plane of the heat shield and perpendicular to a direction in which the two cutouts are spaced apart.

7. The support structure of claim 6, wherein the cutouts at circumferential positions overlapping with circumferential positions of the side rods each have a stepped shape.

8. The support structure of any one of claims 1 to 7, wherein at least some of the heat shields comprise at least three support pins projecting away from a bottom planar face of the heat shield.

9. A wafer boat comprising:
a top member and a bottom member spaced apart along a central axis of the wafer boat;
at least three rods, each extending between the top member and the bottom member;
wherein the rods are hollow along a lower section of the rods and solid along an upper section of the rods.

10. The wafer boat of claim 9, wherein the upper section is at least twice as long as the lower section.

11. The wafer boat of claim 9 or 10, wherein a wall thickness of the rods at the lower section is between 2mm and 4mm.

12. The wafer boat of any one of claims 9 to 11, wherein the upper section of the rods comprises a plurality of supports for supporting wafers.

13. The wafer boat of any one of claims 9 to 12, wherein the rods comprise slots at the lower section for supporting heat shields.

14. The wafer boat of any one of claims 9 to 13, comprising a plurality of heat shields disposed in the lower section of the wafer boat and spaced apart along the central axis, the heat shields each having a diameter which is greater than twice a distance from any rod to the central axis.

15. The wafer boat of claim 14, wherein the heat shields comprise cutouts at circumferential positions overlapping with circumferential positions of the rods.

16. The wafer boat of claim 14 or 15, wherein the at least three rods comprise first and second side rods and a back rod, the first and second side rods being positioned so as to provide an opening opposite the back rod, the opening having a width of less than a diameter of the heat shields.

17. The wafer boat of claim 16, wherein the cutouts at circumferential positions overlapping with circumferential positions of the side rods each have a shape such that a shortest distance between the two cutouts increases along a direction in a plane of the heat shield and perpendicular to a direction in which the two cutouts are spaced apart.

18. The wafer boat of claim 17, wherein the cutouts at circumferential positions overlapping with circumferential positions of the side rods each have a stepped shape.

19. The wafer boat of any one of claims 14 to 18, wherein at least some of the heat shields comprise at least three support pins projecting away from a planar face of the heat shield.

20. The wafer boat of claim 19, wherein the heat shields are stacked in the wafer boat such that an upper heat shield placed upon a lower heat shield is supported by the support pins of the upper heat shield which contact the lower heat shield.
